# FASCICULE DE BREVET EUROPEEN

(11) **EP 1 418 625 B1**
(45) Date de publication et mention de la délivrance du brevet: **08.05.2019**
(21) Numéro de dépôt: 03292527.3
(22) Date de dépôt: 13.10.2003
(51) Int. Cl.: H01L 29/788, B82Y 10/00

(54) **Procédé de mémorisation d'une donnée binaire dans une cellule-mémoire d'un circuit intégré de mémoire, circuit intégré correspondant et procédé de fabrication**
Verfahren zur Speicherung binäre Daten in eine Speicherzelle einer integrierten Speicherschaltung, entsprechende integrierte Schaltung und Verfahren zur Herstellung
Method to store a binary data in a memory cell in a memory integrated circuit, corresponding integrated circuit and fabrication process

(30) Priorité: 05.11.2002 FR 0213838
(43) Date de publication de la demande: 12.05.2004
(73) Titulaire: STMicroelectronics SA, 92120 Montrouge (FR)
(72) Inventeur: Mazoyer, Pascale, 38420 Domene (FR); Villaret, Alexandre, 38000 Grenoble (FR); Skotnicki, Thomas, 38920 Crolles Montfort (FR)
(74) Mandataire: Zapalowicz, Francis

(56) Documents cités:
- EP-A- 1 168 456
- WO-A-98/50958
- US-A- 5 633 178
- US-A- 5 830 575
- US-A- 5 937 295
- US-A- 6 090 666
- US-A- 6 128 243
- US-B1- 6 330 184
- US-B1- 6 330 184
- DE BLAUWE J: "Nanocrystal nonvolatile memory devices" IEEE TRANSACTIONS ON NANOTECHNOLOGY, MARCH 2002, IEEE, USA, vol. 1, no. 1, pages 72-77, XP008018706 ISSN: 1536-125X

## Description

L'invention concerne les mémoires.

A l'heure actuelle, on distingue essentiellement trois types de dispositifs industriels à effet mémoire intégrés sur silicium.

Les matrices de type DRAM (Dynamic Random Access Memory), c'est-à-dire les mémoires vives dynamiques, permettent de lire et d'écrire individuellement chaque cellule élémentaire qui les constitue. Ces cellules de mémoire vive dynamique sont compactes puisqu'elles sont formées d'un transistor et d'un condensateur. Elles sont par ailleurs assez rapides en temps d'accès (typiquement de l'ordre de 40 à 70 nanosecondes) mais nécessitent un rafraîchissement fréquent de l'information contenue dans le condensateur de la cellule, essentiellement en raison des fuites des jonctions du transistor de la cellule.

Il existe également des matrices SRAM (Static Random Access Memory) c'est-à-dire des matrices de mémoire vive statique. Les cellules de mémoire vive statique sont adressables individuellement, présentent des temps de cycle court (temps d'accès de 6 à 70 nanosecondes) et retiennent l'information aussi longtemps qu'elles sont alimentées. Ces cellules-mémoire restent cependant handicapées par leur faible densité puisqu'une cellule se compose généralement de 6 transistors.

On connaît encore les mémoires dites non-volatiles (par exemple les mémoires dites "flash") qui peuvent retenir une information pendant plusieurs années à l'intérieur d'une zone flottante isolée par de l'oxyde, et ce sans rafraîchissement ni alimentation. Ces mémoires sont compactes puisqu'elles sont formées d'un seul transistor, mais le mécanisme d'écriture par effet tunnel à travers l'oxyde d'isolement de la zone flottante est lent et nécessite de fortes polarisations avec des temps d'accès pouvant varier de l'ordre de la microseconde jusqu'à la milliseconde. De plus, ces cellules ne sont pas adressables individuellement à l'effacement.

On connaît par ailleurs par le brevet américain n° 5 633 178, une cellule-mémoire non volatile formée d'un seul transistor à grille isolée et dont l'oxyde de grille renferme des pièges à électrons disposés au contact du substrat. L'écriture d'un "1" logique ou d'un "0" logique dans la cellule-mémoire s'effectue par un déplacement vertical de charges de façon à soit remplir les pièges à électrons, soit les vider. La localisation de pièges à électrons à l'interface entre le diélectrique de grille et le substrat est particulièrement difficile à maîtriser d'un point de vue technologie.

On connaît également par le brevet américain n° 6 128 243 une cellule-mémoire à jonction tunnel (mémoire MTJ) comportant des cristaux de matériau semi-conducteur dans l'oxyde de grille du transistor constituant cette cellule. Une telle cellule est utilisée comme cellule de secours en tant que support de l'information d'une mémoire SRAM pendant une éventuelle coupure d'alimentation. Par ailleurs, le mécanisme de stockage des charges dans cette cellule de l'art antérieur repose sur un transfert vertical des charges depuis le canal jusqu'aux cristaux. L'écriture s'effectue alors par électrons chauds ou par courant tunnel et l'effacement par courant tunnel.

Le brevet US6330184 décrit un circuit intégré de mémoire comprenant des nano-cristaux dans la couche isolante de grille.

L'invention vise à proposer une structure de mémoire totalement différente de celles existant dans l'art antérieur.

L'invention vise à proposer une mémoire présentant des performances hybrides de celles des cellules flash et DRAM classiques, tout en s'affranchissant de leurs limitations respectives. Ainsi, un but de l'invention est de proposer un point mémoire adressable à l'écriture comme à la lecture tout en disposant de la compacité d'un seul transistor. Par ailleurs, ces modes de lecture et d'écriture permettent un temps d'accès à l'information de quelques nanosecondes.

Différents aspects, modes de mise en oeuvre et de réalisation de l'invention sont définis dans les revendications.

L'invention propose donc un circuit intégré de mémoire, comprenant au moins une cellule-mémoire formée d'un seul transistor dont la grille possède une face inférieure isolée de la région de canal par une couche d'isolation comportant au moins une succession de puits de potentiels sensiblement disposés à distance de la grille et de la région de canal dans un plan sensiblement parallèle à la face inférieure de la grille. Les puits de potentiels sont aptes à contenir une charge électrique confinée dans ledit plan et déplaçable sur commande dans ledit plan vers une première région de confinement voisine de la région de source ou vers une deuxième région de confinement voisine de la région de drain, de façon à définir deux états-mémoire pour la cellule.

Les mécanismes de transport de charge dans la cellule selon l'invention sont parallèles au canal de conduction. La cellule selon l'invention se distingue donc des cellules de l'art antérieur décrites dans le brevet américain n° 5 633 178 et dans le brevet américain n° 6 128 243 dans lesquels les mécanismes de transport sont perpendiculaires au canal de conduction. En outre, la localisation selon l'invention des puits de potentiel à distance du substrat est beaucoup plus facilement ajustable d'un point de vue technologique que la localisation de pièges d'électrons au contact du substrat.

Par ailleurs, par rapport à la cellule-mémoire du brevet américain 5 633 178, la cellule-mémoire selon l'invention présente un effet mémoire plus important, c'est-à-dire une durée de rétention plus importante.

Une façon particulièrement simple technologiquement de réaliser les puits de potentiel consiste à prévoir, en tant que couche d'isolation, un enrobage diélectrique enrobant des nodules formant ces puits de potentiel. Ces nodules sont alors aptes à porter ladite charge électrique. En d'autres termes, selon ce mode de réalisation, on utilise une architecture de transistor MOS classique dans laquelle est intercalée une couche de nodules entre la grille et le canal du transistor.

D'une façon générale, les nodules peuvent être formés d'un matériau cristallin dont la bande de conduction a un niveau inférieur au niveau de la bande de conduction du matériau diélectrique inter-nodules.

Là, plusieurs possibilités sont également offertes.

Les nodules peuvent, par exemple, comporter une charge électrique intrinsèque. C'est le cas lorsqu'ils sont par exemple formés d'un matériau semi-conducteur, par exemple du silicium ou un alliage de silicium.

Les nodules peuvent être également exempts de charge électrique intrinsèque; C'est le cas par exemple lorsqu'ils sont formés d'un matériau isolant, par exemple du nitrure de silicium.

Dans l'un ou l'autre des cas mentionnés ci-dessus, le matériau diélectrique inter-nodules peut être par exemple du dioxyde de silicium qui est un matériau présentant en microélectronique un niveau de bande de conduction particulièrement élevé.

Lorsque les nodules sont exempts de charge électrique intrinsèque, il est alors nécessaire d'injecter une charge électrique dans l'enrobage diélectrique de façon à peupler les nodules. Ainsi, il est alors prévu des moyens d'injection aptes à injecter ladite charge électrique dans l'enrobage de façon à charger certains au moins des nodules.

Ceci n'est pas indispensable lorsque les nodules sont formés d'un matériau semi-conducteur puisque dans ce cas ils comportent une charge électrique intrinsèque. Cependant, dans certaines applications, il peut être avantageux d'injecter, par des moyens d'injection, une charge électrique supplémentaire dans l'enrobage de façon à charger certains au moins des nodules.

Selon un mode de réalisation de l'invention, les moyens d'injection comportent des moyens de polarisation aptes à polariser la grille. Ceci étant, afin de pouvoir charger les nodules avec une charge électrique ou une charge électrique supplémentaire selon le cas, il convient que, puisque le courant d'injection circule verticalement du substrat vers la grille ou de la grille vers le substrat, que la quantité de charges arrivant sur les nodules soit supérieure au final à la quantité de charges ayant quitté les nodules. Aussi, une façon d'obtenir ce résultat consiste à prévoir une épaisseur de la partie de la couche d'isolation située entre les puits de potentiel et la grille, différente de l'épaisseur de la partie de la couche d'isolation située entre les puits de potentiels et le canal. Bien entendu, on choisira laquelle de ces deux parties doit être la plus épaisse en fonction du signe de la polarisation appliquée et du signe des charges injectées. Sur le plan pratique, lorsqu'on veut charger les puits de potentiels avec des électrons, on appliquera par exemple une tension de polarisation positive sur l'électrode qui est située du côté du diélectrique le plus épais.

Selon un mode de réalisation de l'invention, les régions de source et de drain sont disposées de façon à être en couplage capacitif avec les puits de potentiels situés au voisinage des extrémités de la couche d'isolation. Il est alors prévu avantageusement des moyens de polarisation aptes à polariser les régions de source et de drain du transistor de façon à déplacer la charge électrique vers la première région de confinement ou vers la deuxième région de confinement.

Une façon d'obtenir que la charge électrique, c'est-à-dire la charge-mémoire, soit confinée dans le plan des nodules mais puisse être déplacée dans ce plan grâce aux polarisations drain-source, consiste à prévoir que l'espace moyen entre deux nodules soit inférieur au diamètre moyen des nodules, et que cet espace moyen entre deux nodules soit également inférieur à la distance moyenne séparant les nodules de la face inférieure de la grille et également inférieure à la distance moyenne séparant les nodules de la région de canal.

L'espace moyen entre deux nodules fixe l'épaisseur de la barrière électronique entre deux puits de potentiels. Aussi, il est préférable que cet espace moyen entre deux nodules soit suffisamment grand pour que la charge électrique, qui est confinée dans l'une ou l'autre de deux régions de confinement, ne se répartisse pas sur l'ensemble des nodules, par effet tunnel. Par ailleurs, cet espace moyen doit être suffisamment petit pour éviter d'utiliser de tensions de polarisation trop importantes et incompatibles avec une application microélectronique de mémoire. Ainsi, à titre indicatif, l'espace moyen entre deux nodules peut être compris entre 0,5 et 3 nanomètres environ.

Par ailleurs, bien que l'invention s'applique en théorie quelle que soit la longueur du canal, les tensions de polarisation à appliquer deviennent d'autant plus importantes que la longueur du canal est grande. Aussi, l'invention est particulièrement intéressante pour des longueurs de canal submicroniques, c'est-à-dire inférieures ou égales à 100 nanomètres, par exemple une longueur égale à 50 nanomètres. Dans ce cas, les tensions de polarisation à appliquer sont de l'ordre de quelques volts et la cellule-mémoire selon l'invention se caractérise alors par sa très petite taille, ce qui la rend particulièrement intéressante d'un point de vue encombrement surfacique.

De même, l'effet mémoire en lui-même n'est pas limité par l'épaisseur du diélectrique encapsulant les puits de potentiels. Néanmoins, augmenter cette épaisseur de diélectrique conduit à réduire le courant du transistor en lecture. Aussi, en pratique, la limite sur l'épaisseur de l'enrobage diélectrique est fixée par le seuil de détection de l'amplificateur de lecture. A l'heure actuelle, on pourra choisir une épaisseur de la partie de la couche d'isolation située entre les puits de potentiels et la grille comprise entre environ 1 nanomètre et environ 10 nanomètres. Cette même fourchette pourra également être appliquée pour l'épaisseur de la partie de la couche d'isolation située entre les puits de potentiels et le canal.

Le circuit de mémoire selon l'invention comporte également selon un mode de réalisation de l'invention, des moyens de lecture aptes pour une polarisation de grille donnée, à mesurer le courant de drain. Ceci va permettre de déterminer si le contenu de la mémoire est un "0" ou un "1".

De façon à améliorer le couplage capacitif entre les régions de source et de drain et les puits de potentiels situés aux extrémités de la couche d'isolation, il est particulièrement avantageux que les régions de source et de drain viennent au contact des extrémités latérales de la couche d'isolation.

Le circuit de mémoire selon l'invention comporte également, selon l'invention, un plan-mémoire formé de plusieurs cellules-mémoire, chaque cellule-mémoire étant adressable individuellement.

L'invention a également pour objet un procédé de mémorisation d'une donnée binaire dans une cellule-mémoire d'un circuit intégré de mémoire, la cellule étant formée d'un seul transistor dont la grille possède une face inférieure isolée de la région de canal par une couche d'isolation.

Selon une caractéristique générale de l'invention, on confine une charge électrique à l'intérieur de la couche d'isolation à distance de la grille et de la région de canal dans au moins un plan sensiblement parallèle à la face inférieure de la grille, et on déplace la charge électrique sur commande dans ledit plan vers une première région de confinement voisine de la région de source ou vers une deuxième région de confinement voisine de la région de drain, de façon à définir deux états mémoire pour la cellule correspondant aux deux valeurs logiques de la donnée binaire.

Selon un mode de mise en oeuvre de l'invention, on déplace la charge électrique dans un sens ou dans l'autre en fonction du signe de la différence entre la tension de polarisation de drain et la tension de polarisation de source.

On peut également si on le souhaite, injecter une charge électrique dans la couche d'isolation de façon à charger certains au moins des puits potentiels.

On peut injecter la charge électrique en polarisant la grille, l'épaisseur de la partie de la couche d'isolation située entre les puits de potentiels et la grille étant alors différente de l'épaisseur de la partie de la couche d'isolation située entre les puits de potentiels et le canal.

On peut lire le contenu de la cellule-mémoire en mesurant le courant de drain pour une polarisation de grille donnée.

L'invention a également pour objet un procédé de fabrication d'un circuit intégré de mémoire comprenant la réalisation d'au moins une cellule-mémoire comportant :
- la formation sur un substrat semi-conducteur d'une couche d'isolation comportant au moins une succession de puits de potentiels sensiblement disposés à distance de la surface supérieure de cette couche d'isolation et de la surface supérieure du substrat, dans un plan sensiblement parallèle à la face supérieure du substrat,
- la formation d'une région de grille sur la surface supérieure de la couche d'isolation, et
- la formation de régions de source et de drain situées de part et d'autre de la grille et en couplage capacitif avec les puits de potentiels situés au voisinage des extrémités de la couche d'isolation.

Selon un mode de mise en oeuvre, la formation de la couche d'isolation comporte la formation d'un enrobage diélectrique enrobant des nodules formant les puits de potentiels.

La formation de l'enrobage et des nodules comporte par exemple la formation d'une couche diélectrique inférieure sur la surface supérieure du substrat, la formation de nodules sur la couche diélectrique inférieure et la formation d'une couche diélectrique supérieure enrobant et recouvrant les nodules.

La formation des nodules peut comporter un dépôt nodulaire d'un matériau cristallin dont la bande de conduction a un niveau inférieur au niveau de la bande de conduction du matériau diélectrique inter-nodules.

Selon un mode de mise en oeuvre, la formation de la grille comporte le dépôt d'une couche de matériau de grille sur la couche d'isolation, la gravure de la couche de matériau de grille avec arrêt sur la couche d'isolation, et la formation d'espaceurs isolants sur les flancs de la grille.

Par ailleurs, la formation des régions de source et de drain comporte une gravure de la couche d'isolation de part et d'autre des espaceurs et une épitaxie de façon à ce que les régions de source et de drain viennent au contact des extrémités de la couche d'isolation.

D'autres avantages et caractéristiques de l'invention apparaîtront à l'examen de la description détaillée, de modes de réalisation et de mise en oeuvre, nullement limitatifs, et des dessins annexés sur lesquels :
- la figure 1 illustre schématiquement une cellule-mémoire selon l'invention,
- les figures 2a et 2b illustrent schématiquement les deux états-mémoire d'une cellule-mémoire selon l'invention,
- la figure 3 représente des courbes relatives à la lecture des états d'une cellule-mémoire selon l'invention,
- les figures 4a et 4b illustrent un premier mode de fabrication d'une cellule-mémoire,
- les figures 5a à 5d illustrent un deuxième mode de fabrication d'une cellule-mémoire selon l'invention,
- la figure 6 illustre schématiquement un circuit intégré de
   mémoire selon l'invention, et,
- la figure 7 illustre un autre mode de réalisation d'une
   cellule-mémoire selon l'invention.

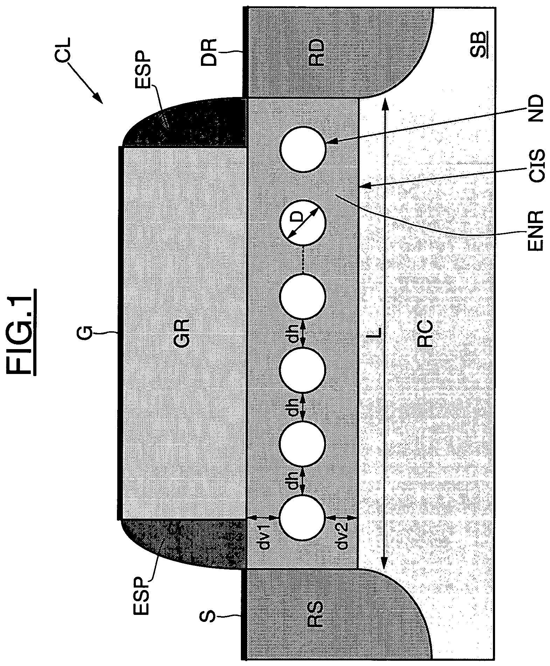

Sur la figure 1, la référence CL désigne une cellule-mémoire selon l'invention. Cette cellule-mémoire est formée d'un seul transistor dont la grille GR est isolée de la région de canal RC située dans un substrat semi-conducteur SB, par exemple en silicium, par une couche d'isolation CIS au sein de laquelle sont noyés des nodules ND.

Les nodules forment ici une succession de puits de potentiels. Bien que ces nodules puissent être formés par tout matériau cristallin à dépôt nodulaire, dont le niveau de la bande de conduction est inférieur au niveau de la bande de conduction de l'enrobage diélectrique ENR disposé entre les nodules et enrobant ceux-ci, on pourra par exemple choisir des nodules de silicium ou bien d'alliage de silicium, (par exemple du silicium germanium). L'enrobage diélectrique ENR pourra alors être par exemple du dioxyde de silicium.

Ces nodules sont disposés dans un plan sensiblement parallèle à la face inférieure de la grille GR ainsi qu'à la face supérieure du substrat SB.

Par ailleurs, ces nodules sont situés à distance de ces deux faces.

Plus précisément, sur la figure 1, la référence dv1 désigne la distance séparant les nodules de la face inférieure de la grille GR et la référence dv2 désigne la distance séparant les nodules de la face supérieure du substrat SB, c'est-à-dire de la région de canal RC.

Bien que sur la figure 1, on ait représenté des nodules régulièrement espacés, en pratique, la répartition de ces nodules dans le plan résulte d'une opération de dépôt nodulaire d'un matériau cristallin. Selon le type de dépôt nodulaire utilisé, il n'est pas exclu que certains des nodules soient plus rapprochés les uns que les autres voire se touche entre eux. Ceci étant, sur la figure 1, la référence dh désigne l'espace moyen entre deux nodules. De même, la référence D désigne le diamètre moyen d'un nodule.

Sur la figure 1, les régions de source RS et de drain RD sont au contact des extrémités latérales de la couche d'isolation CIS. Ces régions de source et de drain réalisent ici, comme on le verra plus en détail après, un couplage avec les nodules situés au voisinage des extrémités de la région d'isolation CIS.

On remarquera donc que dans ce mode de réalisation, la couche d'isolation CIS, c'est-à-dire l'oxyde de grille, se situe sous la surface supérieure de la plaquette semi-conductrice, seule la grille du transistor faisant saillie sur cette surface.

Enfin, des métallisations de source S, de drain DR et de grille G vont permettre l'application de tensions de polarisation, comme on le verra en détail ci-après.

A titre d'exemple, on peut choisir une valeur égale à 1 nanomètre pour dh et une valeur égale à 5 nanomètres pour dv2 et à 8 nanomètres pour dv1. Le diamètre D des nodules pourra être choisi entre 3 nanomètres et 10 nanomètres par exemple.

Dans l'exemple décrit ici, la longueur L du canal RC est prise égale par exemple à 50 nanomètres.

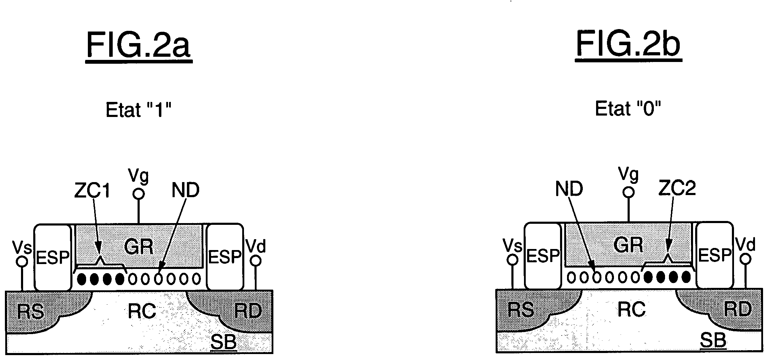

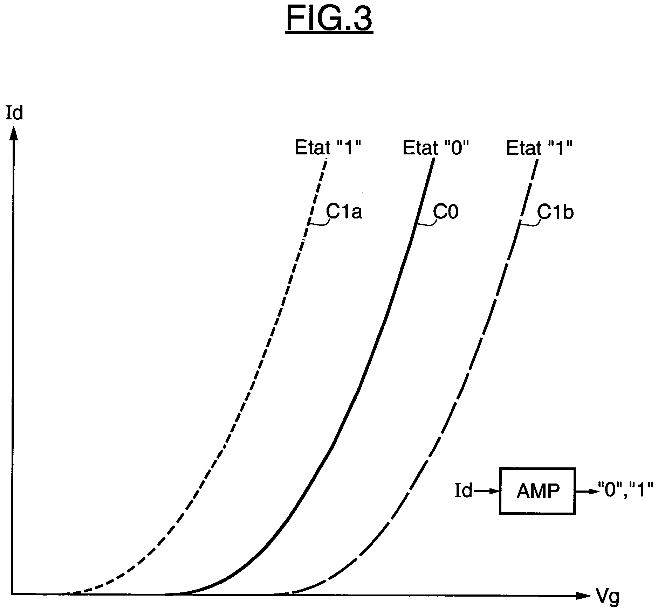

On se réfère maintenant plus particulièrement aux figures 2a, 2b et 3 pour illustrer un mode de fonctionnement de la cellule-mémoire selon l'invention.

Comme indiqué ci-avant, les nodules constituent une succession de puits de potentiels. Ces derniers permettent de confiner une charge électronique au-dessus du canal de conduction, soit dans une première zone de confinement ZC1 voisine de la région de source RS (figure 2a) soit dans une deuxième zone de confinement ZC2 voisine de la région de drain RD (figure 2b).

Le confinement des charges électroniques portées par les nodules dans l'une ou l'autre de ces deux zones définit donc deux états-mémoire pour la cellule correspondant à deux valeurs logiques "1" et "0" d'une donnée binaire destinée à être mémorisée dans cette cellule-mémoire. On peut définir, comme dans l'exemple illustré, que l'état "1" correspond à un confinement des charges dans la zone ZC1 tandis que l'état "0" correspond à un confinement des charges dans la zone ZC2.

La polarisation des régions de source et de drain permettent de transférer les charges électriques, par exemple des électrons, d'un nodule à l'autre, soit vers la zone ZC1 soit vers la zone ZC2 en fonction du signe de la différence de tension Vd-Vs. Ainsi, à titre d'exemple, si le transistor de la cellule-mémoire est un transistor de type NMOS avec la source polarisée à la masse, une tension de polarisation sur le drain Vd négative permettra de confiner les charges dans la zone ZC1 tandis qu'une tension de drain positive permettra de confiner les charges dans la zone ZC2.

Lorsque la polarisation est retirée, la charge électrique reste confinée du côté où elle a été transférée.

Pour l'écriture, la polarisation de la grille est indifférente, étant donné que le déplacement des charges s'effectue parallèlement à la grille et au canal. Ceci étant cette polarisation peut permettre de réduire l'intensité du courant drain-source et par conséquent la consommation de la cellule-mémoire.

Dans l'exemple décrit en référence aux figures 2a et 2b, on aura noté que les régions de source et de drain sont ici constituées de zones diffusées dans le substrat, et ne sont pas en contact avec les extrémités latérales de la couche d'isolation. Le couplage capacitif s'effectue ici par l'intermédiaire des zones d'extension de source et de drain venant au contact sous les extrémités de la couche d'isolation CIS. Bien entendu, le principe de fonctionnement qui vient d'être décrit en référence aux figures 2a et 2b est identique pour le mode de réalisation illustré sur la figure 1.

Les nodules de silicium peuvent comporter un nombre suffisant de charges électriques intrinsèques.

Par contre, si les nodules étaient formés de nitrure de silicium enrobés dans du dioxyde de silicium, ou bien si les nodules de silicium ne comportaient pas un nombre suffisant de charges électriques intrinsèques, il serait alors nécessaire avant de procéder à l'opération d'écriture, d'injecter une charge électrique dans l'enrobage pour peupler certains au moins des nodules. Cette injection s'effectue alors en polarisant par exemple la grille GR avec une tension de polarisation Vg forte, typiquement de l'ordre de quelques volts, pendant un certain temps, par exemple une seconde, de façon à créer un courant tunnel depuis le canal. Les électrons vont alors traverser l'enrobage diélectrique et se charger progressivement sur les nodules. Ceci étant, d'autres électrons vont quitter les nodules pour aller vers la grille GR. Aussi, si au final on souhaite avoir effectivement des charges électriques sur les nodules, il convient de prévoir un enrobage diélectrique dissymétrique de façon à ce que la quantité de charges arrivant sur les nodules soit supérieure à la quantité de charges qui en part. Aussi, dans l'exemple décrit ici dans lequel les charges sont des électrons et dans lequel on polarise la grille, on choisira alors une épaisseur dv1 supérieure à l'épaisseur dv2.

La lecture du contenu de la cellule-mémoire CL réside dans une mesure du courant de drain Id pour une polarisation de grille et de drain données. Ceci est illustré sur la figure 3.

Il faut faire ici la différence entre le cas où les charges stockées sur les nodules sont de même signe que les charges présentes dans le canal ou bien si ces charges stockées sont de signe opposé par rapport aux charges dans le canal de conduction.

La courbe C0 représente l'évolution du courant de drain Id par rapport à la polarisation de grille Vg pour un état "0" de la cellule-mémoire, c'est-à-dire pour le cas où les charges électriques ont été confinées dans la zone ZC2 près du drain.

La courbe C1a représente l'évolution du courant de drain par rapport à la tension de polarisation de grille dans le cas où des charges de signe opposé par rapport aux charges présentes dans le canal de conduction, ont été confinées dans la zone ZC1, c'est-à-dire près de la source.

La courbe C1b illustre l'évolution du courant de drain Id par rapport à la tension de polarisation de grille Vg pour le cas où des charges de même signe que les charges présentes dans le canal de conduction RC ont été stockées dans la zone de confinement ZC1 près de la source.

On voit donc d'une façon générale, pour une polarisation de grille donnée, que le courant de drain Id est différent entre l'état "0" et l'état "1" de la mémoire. Par ailleurs, selon le signe des charges stockées, ce courant de drain dans l'état "1" peut être inférieur ou supérieur au courant de drain dans l'état "0", pour une polarisation de grille donnée.

Quoi qu'il en soit, on connaît, pour une cellule donnée, les valeurs du courant de drain pour une polarisation de grille donnée, dans chacun des états "0" et "1" de la cellule. Aussi, les moyens de lecture vont alors consister en un amplificateur de lecture (AMP) qui va détecter le niveau du courant de drain pour une polarisation de grille donnée et pour une polarisation de drain donnée, et qui va alors en déduire si ce niveau est un niveau haut ou un niveau bas en le comparant à un niveau de réfréence. On en déduira alors le contenu logique de la cellule-mémoire.

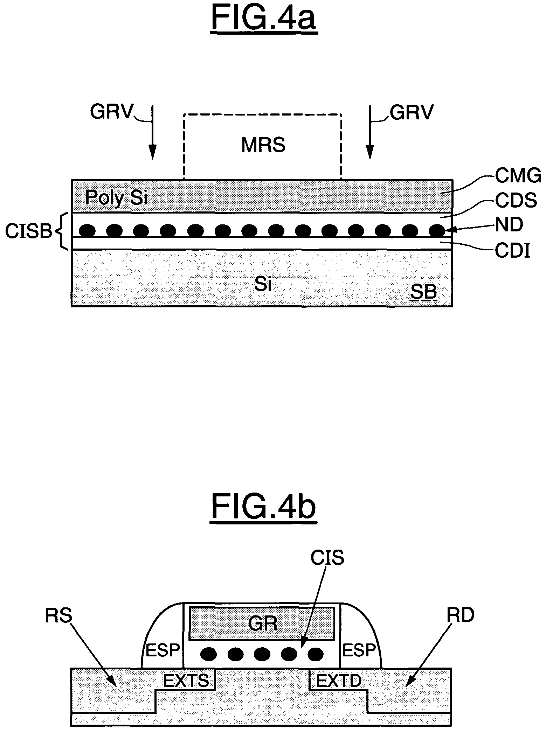

On va maintenant se référer plus particulièrement aux figures 4a et 4b pour illustrer un premier mode de fabrication d'une cellule-mémoire selon l'invention.

Sur la figure 4a, la référence SB désigne un substrat de silicium. On procède à une oxydation thermique du substrat SB de façon à former une couche diélectrique inférieure CDI, en dioxyde de silicium. Puis, on procède à un dépôt nodulaire de silicium de façon à déposer de billes ou nodules de silicium ND sur la couche diélectrique inférieure CDI. A cet égard, le dépôt nodulaire d'un matériau est déjà classique et connu en soi puisqu'il est déjà utilisé pour la fabrication de mémoires à jonctions tunnel (mémoires MTJ). On peut citer les dépôts de nodules par un procédé LPCVD (Dépôt chimique en phase vapeur basse pression) ou bien par un procédé connu par l'homme du métier sous la dénomination anglo-saxonne HSG (Hemispherical Silicon Grain). L'homme du métier pourra également se référer à l'article de Jane D. Bloway intitulé "Nanocristal non-volatil memory devices, IEEE TE Nanotechnology, vol. 1, n° 1 page 72 et suivantes.

Dans le cas où des nodules de nitrure de silicium seraient envisagés, ils pourraient être déposés par une technique LPCVD.

L'étape suivante consiste à déposer de façon classique et connue en soi, une couche de dioxyde de silicium CDS, sur la couche de diélectrique inférieur CDI entre et sur les nodules ND de façon à les enrober et former une couche CISB.

Puis, on dépose de façon classique et connue en soi une couche d'un matériau de grille CMG, par exemple du polysilicium. On grave ensuite par une opération de gravure classique GRV, cette couche CMG de part et d'autre d'un masque de résine MRS de façon à délimiter la grille GR du transistor de la cellule-mémoire. On grave également la couche CISB de façon à former la couche d'isolation CIS.

On procède alors (figure 4b) à une première implantation de dopants dans le substrat de façon à former les zones d'extension EXTS et EXTD des régions de source et de drain. Puis, on forme des espaceurs sur les flancs de la grille GR et de la couche CIS et l'on procède à une deuxième implantation de dopants de façon à réaliser les régions de source et de drain RS et RD.

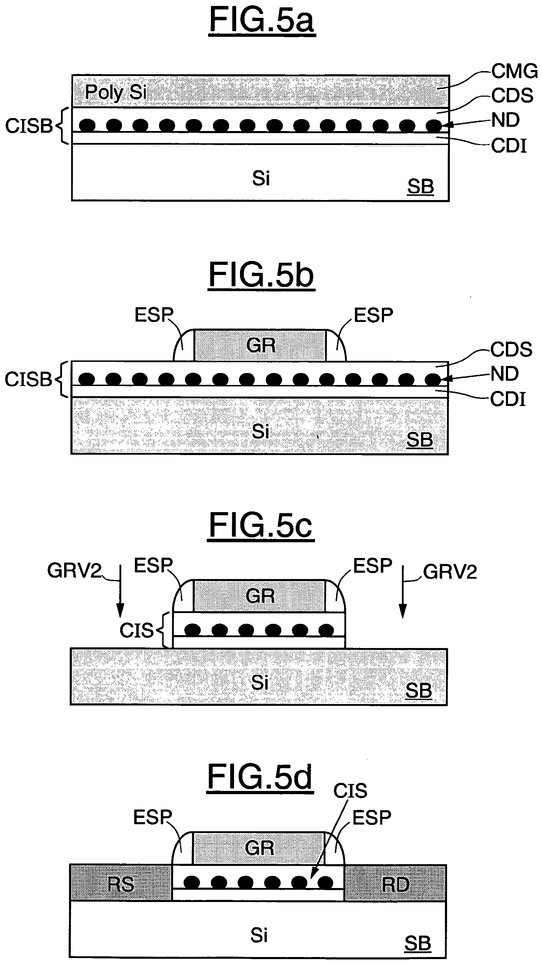

Un deuxième mode de fabrication est illustré sur les figures 5a à 5d.

Les premières phases de ce mode de fabrication (figure 5a) sont analogues à celles qui viennent d'être décrites en référence à la figure 4a.

Par contre, comme illustré sur la figure 5b, au lieu de graver de façon autoalignée à la fois la couche de matériau de grille CMG et la couche CISB, on ne grave que la couche de matériau de grille CMG avec arrêt sur la couche CISB. Puis, on forme des espaceurs sur les flancs de la grille GR.

On procède ensuite à une gravure anisotrope classique GRV2 de la couche CISB, de part et d'autre des espaceurs ESP de façon à former la couche d'isolation CIS (figure 5c).

Puis, comme illustré sur la figure 5d, on procède à une reprise d'épitaxie de silicium de part et d'autre de la couche CIS de façon à former les régions de source et de drain RS et RD qui vont venir au contact des extrémités latérales de la couche CIS.

Ce mode de réalisation présente l'avantage un couplage capacitif plus important entre les régions de source et de drain et les nodules de la couche CIS.

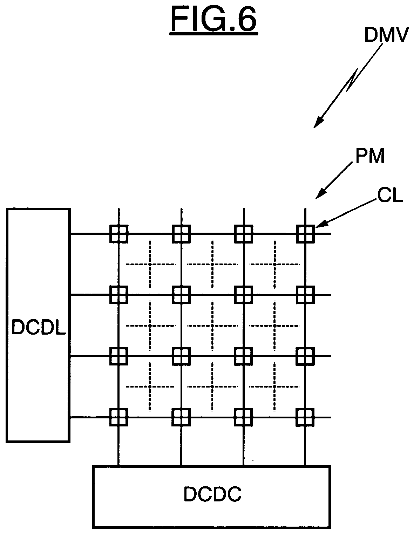

La cellule-mémoire selon l'invention qui vient d'être décrite peut être bien entendu associée de façon matricielle à plusieurs autres cellules-mémoire du même type de façon à former comme illustré sur la figure 6, un plan mémoire PM. On associe alors à ce plan-mémoire de façon classique, notamment un décodeur lignes DCDL et un décodeur colonnes DCDC de façon à pouvoir adresser individuellement chaque cellule-mémoire CL du plan-mémoire. Le circuit intégré de mémoire DMV constitue alors une mémoire présentant des propriétés hybrides de celles des mémoires flash et DRAM tout en s'affranchissant de leur limitations respectives. Notamment, ce circuit de mémoire est composé de cellules adressables individuellement tout en disposant de la compacité d'un seul transistor. Et, les modes de lecture et d'écriture permettent un temps d'accès à l'information de quelques nanosecondes.

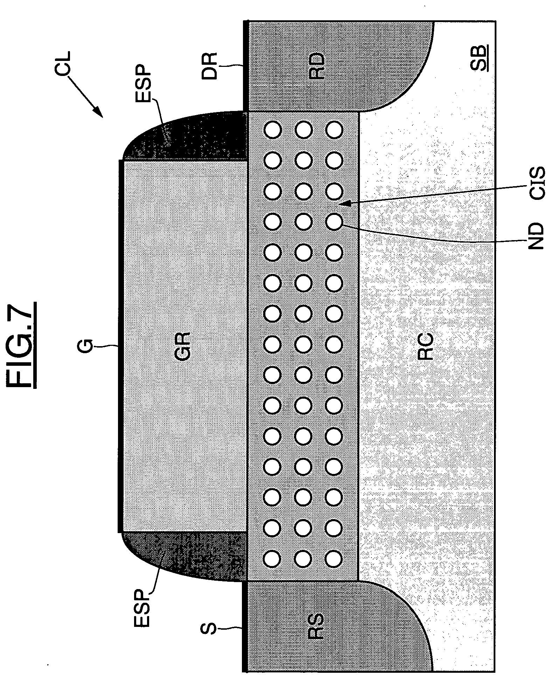

Par ailleurs, alors que l'on vient de décrire une cellule-mémoire ne comportant qu'une seule couche de nodules, on peut envisager de réaliser comme illustré sur la figure 7, une cellule-mémoire comportant plusieurs successions superposées de puits de potentiel, par exemple plusieurs couches de nodules superposées, et respectivement disposés dans des plans parallèles. Le fonctionnement d'une telle cellule est alors identique à celui qui vient d'être décrit, mais une telle structure permet d'amplifier la différence entre l'état « 0 » et l'état « 1 ».

## Revendications

1. Circuit intégré de mémoire, **caractérisé par le fait qu'**il comprend au moins une cellule-mémoire formée d'un seul transistor dont la grille (GR) possède une face inférieure isolée de la région de canal (RC) par une couche d'isolation (CIS) comportant au moins une succession de puits de potentiels (ND) sensiblement disposés à distance de la grille et de la région de canal dans un plan sensiblement parallèle à la face inférieure de la grille, et **par le fait que** ces puits de potentiel (ND) sont aptes à contenir une charge électrique confinée dans ledit plan et déplaçable sur commande dans ledit plan vers une première région de confinement voisine de la région de source (RS) ou vers une deuxième région de confinement voisine de la région de drain (RD), de façon à définir deux états mémoire pour la cellule, les régions de source (RS) et de drain (RD) venant au contact des extrémités latérales de la couche d'isolation.

2. Circuit selon la revendication 1, **caractérisé par le fait que** la couche d'isolation (CIS) comporte un enrobage diélectrique (ENR) enrobant des nodules formant les puits de potentiel, ces nodules étant aptes à porter ladite charge électrique.

3. Circuit selon la revendication 2, **caractérisé par le fait que** les nodules (ND) sont formés d'un matériau cristallin dont la bande de conduction a un niveau inférieur au niveau de la bande de conduction du matériau diélectrique inter-nodules (ENR).

4. Circuit selon la revendication 3, **caractérisé par le fait que** les nodules (ND) comportent une charge électrique intrinsèque.

5. Circuit selon la revendication 4, **caractérisé par le fait que** les nodules (ND) sont formés d'un matériau semi-conducteur, par exemple du silicium ou un alliage de silicium.

6. Circuit selon la revendication 4 ou 5, **caractérisé par le fait qu'**il comporte des moyens d'injection (Vg) aptes à injecter une charge électrique supplémentaire dans l'enrobage de façon à charger certains au moins des nodules.

7. Circuit selon la revendication 3, **caractérisé par le fait que** les nodules (ND) sont exempts de charge électrique intrinsèque, et **par le fait qu'**il comporte des moyens d'injection aptes à injecter ladite charge électrique dans l'enrobage de façon à charger certains au moins des nodules.

8. Circuit selon la revendication 6 ou 7, **caractérisé par le fait que** les moyens d'injection comportent des moyens de polarisation (Vg) aptes à polariser la grille, et **par le fait que** l'épaisseur (dv1) de la partie de la couche d'isolation située entre les puits de potentiel et la grille étant différente de l'épaisseur (dv2) de la partie de la couche d'isolation située entre les puits de potentiel et le canal.

9. Circuit selon la revendication 7, **caractérisé par le fait que** les nodules (ND) sont formés d'un matériau isolant, par exemple du nitrure de silicium.

10. Circuit selon la revendication 5 ou 9, **caractérisé par le fait que** le matériau diélectrique inter-nodules (ENR) comporte du dioxyde de silicium.

11. Circuit selon l'une des revendications précédentes, **caractérisé par le fait que** l'espace moyen (dh) entre deux nodules est inférieur au diamètre moyen (D) des nodules, inférieur à la distance moyenne (dv1) séparant les nodules de la face inférieure de la grille et inférieur à la distance moyenne (dv2) séparant les nodules de la région de canal.

12. Circuit selon la revendication 11, **caractérisé par le fait que** l'espace moyen (dh) entre deux nodules est compris entre 0,5 et 3 nanomètres environ.

13. Circuit selon l'une des revendications précédentes, **caractérisé par le fait que** la longueur (L) du canal est inférieure ou égale à 100 nanomètres, par exemple égale à 50 nanomètres.

14. Circuit selon l'une des revendications précédentes, **caractérisé par le fait que** l'épaisseur (dv1) de la partie de la couche d'isolation située entre les puits de potentiel et la grille est comprise entre environ 1 nanomètre et environ 10 nanomètres, et **par le fait que** l'épaisseur (dv2) de la partie de la couche d'isolation située entre les puits de potentiel et le canal est comprise entre environ 1 nanomètre et environ 10 nanomètres.

15. Circuit selon l'une des revendications précédentes, **caractérisé par le fait que** les régions de source et de drain sont disposées de façon à être en couplage capacitif avec les puits de potentiels (ND) situés au voisinage des extrémités de la couche d'isolation (CIS), et **par le fait qu'**il comporte des moyens de polarisation (Vd, Vs) aptes à polariser les régions de source et de drain du transistor de façon à déplacer la charge électrique vers la première région de confinement (ZC1) ou vers la deuxième région de confinement (ZC2).

16. Circuit selon l'une des revendications précédentes, **caractérisé par le fait qu'**il comporte des moyens de lecture aptes pour une polarisation de grille donnée, à mesurer le courant de drain.

17. Circuit selon l'une des revendications précédentes, **caractérisé par le fait que** la couche d'isolation comporte plusieurs successions de puits de potentiel respectivement disposées dans des plans distincts, tous sensiblement parallèles à la face inférieure de la grille.

18. Circuit selon l'une des revendications précédentes, **caractérisé par le fait qu'**il comporte un plan mémoire (PM) formé de plusieurs cellules-mémoire, chaque cellule-mémoire étant adressable individuellement.

19. Procédé de mémorisation d'une donnée binaire dans une cellule-mémoire d'un circuit intégré de mémoire, la cellule comportant un seul transistor dont la grille possède une face inférieure isolée de la région de canal par une couche d'isolation, **caractérisé par le fait qu'**on confine une charge électrique à l'intérieur de la couche d'isolation (CIS) à distance de la grille et de la région de canal dans au moins un plan sensiblement parallèle à la face inférieure de la grille, et on déplace la charge électrique sur commande dans ledit plan vers une première région de confinement (ZC1) voisine de la région de source ou vers une deuxième région de confinement (ZC2) voisine de la région de drain, en fonction du signe de la différence entre la tension de polarisation de drain (Vd) et la tension de polarisation de source (Vs), de façon à définir deux états mémoire pour la cellule correspondant aux valeurs logiques de la donnée binaire.

20. Procédé selon la revendication 19, **caractérisé par le fait qu'**on confine la charge électrique dans des puits de potentiel formés dans la couche d'isolation.

21. Procédé selon la revendication 20, **caractérisé par le fait qu'**on injecte au préalable une charge électrique dans la couche d'isolation.

22. Procédé selon la revendication 21, **caractérisé par le fait qu'**on injecte la charge électrique en polarisant la grille, l'épaisseur de la partie de la couche d'isolation située entre les nodules et la grille étant différente de l'épaisseur de la partie de la couche d'isolation située entre les puits de potentiel et le canal.

23. Procédé selon l'une des revendications 19 à 22, **caractérisé par le fait qu'**on lit le contenu de la cellule-mémoire en mesurant le courant de drain pour une polarisation de grille donnée.

24. Procédé selon l'une des revendications 19 à 23, **caractérisé par le fait qu'**on confine la charge électrique dans des puits de potentiels formés de nodules aptes à porter la charge électrique et enrobés dans un enrobage diélectrique.

25. Procédé selon l'une des revendications 19 à 24, **caractérisé par le fait qu'**on confine la charge électrique dans plusieurs plans distincts sensiblement parallèles à la face inférieure de la grille.

26. Procédé de fabrication d'un circuit intégré de mémoire, **caractérisé par le fait qu'**il comprend la réalisation d'au moins une cellule-mémoire comportant
- la formation sur un substrat semi-conducteur d'une couche d'isolation (CIS) comportant au moins une succession de puits de potentiels sensiblement disposés à distance de la surface supérieure de cette couche d'isolation et de la surface supérieure du substrat, dans un plan sensiblement parallèle à la face supérieure su substrat,
- la formation d'une région de grille (GR) sur la surface supérieure de la couche d'isolation, cette formation comportant le dépôt d'une couche de matériau de grille sur la couche d'isolation, la gravure de la couche de matériau de grille avec arrêt sur la couche d'isolation, et la formation d'espaceurs isolants sur les flancs de la grille, et
- la formation de régions de source (RS) et de drain (RD) de part et d'autre de la grille et en couplage capacitif avec les puits de potentiels situés au voisinage des extrémités de la couche d'isolation, cette formation comportant une gravure de la couche d'isolation de part et d'autre des espaceurs et une épitaxie de façon à ce que les régions de source et de drain viennent au contact des extrémités de la couche d'isolation.

27. Procédé selon la revendication 26, **caractérisé par le fait que** la formation de la couche d'isolation comporte la formation d'un enrobage diélectrique (ENR) enrobant des nodules (ND) formant les puits de potentiel.

28. Procédé selon la revendication 27, **caractérisé par le fait que** la formation de l'enrobage et des nodules comporte la formation d'une couche diélectrique inférieure (CDI) sur la surface supérieure du substrat, la formation de nodules sur la couche diélectrique inférieure, et la formation d'une couche diélectrique supérieure (CDS) enrobant et recouvrant les nodules.

29. Procédé selon la revendication 28, **caractérisé par le fait que** la formation des nodules (ND) comporte un dépôt nodulaire d'un matériau cristallin dont la bande de conduction a un niveau inférieur au niveau de la bande de conduction du matériau diélectrique inter-nodules.

## Patentansprüche

1. Integrierte Speicherschaltung, **dadurch gekennzeichnet, dass** sie mindestens eine Speicherzelle enthält, die von einem einzigen Transistor gebildet wird, dessen Gate (GR) eine Unterseite besitzt, die vom Kanal-Bereich (RC) durch eine Isolierschicht (CIS) isoliert wird, die mindestens eine Folge von Potentialsenken (ND) aufweist, die im Wesentlichen im Abstand zum Gate und zum Kanal-Bereich in einer Ebene im Wesentlichen parallel zur Unterseite des Gates angeordnet sind, und dass diese Potentialsenken (ND) eine elektrische Ladung enthalten können, die in der Ebene eingeschlossen ist und auf Befehl in der Ebene zu einem dem Source-Bereich (RS) benachbarten ersten Einschluss-Bereich oder zu einem dem Drain-Bereich (RD) benachbarten zweiten Einschluss-Bereich verschoben werden kann, um zwei Speicherzustände für die Zelle zu definieren, wobei die Source- (RS) und Drain-Bereiche (RD) mit den seitlichen Enden der Isolierschicht in Kontakt kommen.

2. Schaltung nach Anspruch 1, **dadurch gekennzeichnet, dass** die Isolierschicht (CIS) eine dielektrische Umhüllung (ENR) aufweist, die die Potentialsenken bildende Knoten umhüllt, wobei diese Knoten die elektrische Ladung tragen können.

3. Schaltung nach Anspruch 2, **dadurch gekennzeichnet, dass** die Knoten (ND) aus einem kristallinen Material gebildet werden, dessen Leitungsband einen niedrigeren Pegel hat als der Pegel des Leitungsbands des dielektrischen Materials zwischen Knoten (ENR).

4. Schaltung nach Anspruch 3, **dadurch gekennzeichnet, dass** die Knoten (ND) eine intrinsische dielektrische Ladung aufweisen.

5. Schaltung nach Anspruch 4, **dadurch gekennzeichnet, dass** die Knoten (ND) aus einem Halbleitermaterial gebildet werden, zum Beispiel Silicium oder eine Siliciumlegierung.

6. Schaltung nach Anspruch 4 oder 5, **dadurch gekennzeichnet, dass** sie Injektionseinrichtungen (Vg) aufweist, die eine zusätzliche elektrische Ladung in die Umhüllung injizieren können, um zumindest bestimmte der Knoten zu laden.

7. Schaltung nach Anspruch 3, **dadurch gekennzeichnet, dass** die Knoten (ND) keine intrinsische elektrische Ladung enthalten, und dass sie Injektionseinrichtungen aufweist, die die elektrische Ladung in die Umhüllung injizieren können, um zumindest bestimmte der Knoten zu laden.

8. Schaltung nach Anspruch 6 oder 7, **dadurch gekennzeichnet, dass** die Injektionseinrichtungen Vorspannungseinrichtungen (Vg) aufweisen, die das Gate vorspannen können, und dass die Dicke (dv1) des Teils der Isolierschicht, der sich zwischen den Potentialsenken und dem Gate befindet, sich von der Dicke (dv2) des Teils der Isolierschicht unterscheidet, der sich zwischen den Potentialsenken und dem Kanal befindet.

9. Schaltung nach Anspruch 7, **dadurch gekennzeichnet, dass** die Knoten (ND) aus einem Isoliermaterial gebildet werden, zum Beispiel Siliciumnitrid.

10. Schaltung nach Anspruch 5 oder 9, **dadurch gekennzeichnet, dass** das dielektrische Material zwischen Knoten (ENR) Siliciumdioxid aufweist.

11. Schaltung nach einem der vorhergehenden Ansprüche, **dadurch gekennzeichnet, dass** der mittlere Zwischenraum (dh) zwischen zwei Knoten kleiner als der mittlere Durchmesser (D) der Knoten, kleiner als der die Knoten von der Unterseite des Gates trennende mittlere Abstand (dv1) und kleiner als der die Knoten vom Kanal-Bereich trennende mittlere Abstand (dv2) ist.

12. Schaltung nach Anspruch 11, **dadurch gekennzeichnet, dass** der mittlere Zwischenraum (dh) zwischen zwei Knoten zwischen etwa 0,5 und 3 Nanometer liegt.

13. Schaltung nach einem der vorhergehenden Ansprüche, **dadurch gekennzeichnet, dass** die Länge (L) des Kanals kleiner als oder gleich 100 Nanometer ist, zum Beispiel gleich 50 Nanometer.

14. Schaltung nach einem der vorhergehenden Ansprüche, **dadurch gekennzeichnet, dass** die Dicke (dv1) des Teils der Isolierschicht, der sich zwischen den Potentialsenken und dem Gate befindet, zwischen etwa 1 Nanometer und etwa 10 Nanometer liegt, und dass die Dicke (dv2) des Teils der Isolierschicht, der sich zwischen den Potentialsenken und dem Kanal befindet, zwischen etwa 1 Nanometer und etwa 10 Nanometer liegt.

15. Schaltung nach einem der vorhergehenden Ansprüche, **dadurch gekennzeichnet, dass** die Source- und Drain-Bereiche so angeordnet sind, dass sie in kapazitiver Kopplung mit den Potentialsenken (ND) sind, die sich in der Nähe der Enden der Isolierschicht (CIS) befinden, und dass sie Vorspannungseinrichtungen (Vd, Vs) aufweist, die die Source- und Drain-Bereiche des Transistors so vorspannen können, dass die elektrische Ladung zum ersten Einschluss-Bereich (ZC1) oder zum zweiten Einschluss-Bereich (ZC2) verschoben wird.

16. Schaltung nach einem der vorhergehenden Ansprüche, **dadurch gekennzeichnet, dass** sie Ableseeinrichtungen aufweist, die für eine gegebene Gate-Vorspannung den Drain-Strom messen können.

17. Schaltung nach einem der vorhergehenden Ansprüche, **dadurch gekennzeichnet, dass** die Isolierschicht mehrere Folgen von Potentialsenken aufweist, die in unterschiedlichen Ebenen angeordnet sind, alle im Wesentlichen parallel zur Unterseite des Gates.

18. Schaltung nach einem der vorhergehenden Ansprüche, **dadurch gekennzeichnet, dass** sie eine aus mehreren Speicherzellen geformte Speicherebene (PM) aufweist, wobei jede Speicherzelle einzeln adressierbar ist.

19. Verfahren zum Speichern eines Binärdatenwerts in einer Speicherzelle einer integrierten Speicherschaltung, wobei die Zelle einen einzigen Transistor aufweist, dessen Gate eine Unterseite besitzt, die vom Kanal-Bereich durch eine Isolierschicht isoliert ist, **dadurch gekennzeichnet, dass** eine elektrische Ladung im Inneren der Isolierschicht (CIS) in Abstand zum Gate und zum Kanal-Bereich in mindestens einer Ebene im Wesentlichen parallel zur Unterseite des Gates eingeschlossen wird, und die elektrische Ladung auf Befehl in der Ebene zu einem ersten Einschluss-Bereich (ZC1) neben dem Source-Bereich oder zu einem zweiten Einschluss-Bereich (ZC2) neben dem Drain-Bereich verschoben wird, abhängig vom Vorzeichen der Differenz zwischen der Drain-Vorspannung (Vd) und der Source-Vorspannung (Vs), um zwei Speicherzustände für die Zelle zu definieren, die den logischen Werten des Binärdatenwerts entsprechen.

20. Verfahren nach Anspruch 19, **dadurch gekennzeichnet, dass** die elektrische Ladung in in der Isolierschicht gebildeten Potentialsenken eingeschlossen wird.

21. Verfahren nach Anspruch 20, **dadurch gekennzeichnet, dass** vorher eine elektrische Ladung in die Isolierschicht injiziert wird.

22. Verfahren nach Anspruch 21, **dadurch gekennzeichnet, dass** die elektrische Ladung injiziert wird, indem das Gate vorgespannt wird, wobei die Dicke des Teils der Isolierschicht, der sich zwischen den Knoten und dem Gate befindet, sich von der Dicke des Teils der Isolierschicht unterscheidet, der sich zwischen den Potentialsenken und dem Kanal befindet.

23. Verfahren nach einem der Ansprüche 19 bis 22, **dadurch gekennzeichnet, dass** der Inhalt der Speicherzelle ausgelesen wird, indem der Drain-Strom für eine gegebene Gate-Vorspannung gemessen wird.

24. Verfahren nach einem der Ansprüche 19 bis 23, **dadurch gekennzeichnet, dass** die elektrische Ladung in Potentialsenken eingeschlossen wird, die von Knoten gebildet werden, die die elektrische Ladung tragen können und von einer dielektrischen Umhüllung umhüllt sind.

25. Verfahren nach einem der Ansprüche 19 bis 24, **dadurch gekennzeichnet, dass** die elektrische Ladung in mehreren unterschiedlichen Ebenen im Wesentlichen parallel zur Unterseite des Gates eingeschlossen wird.

26. Verfahren zur Herstellung einer integrierten Speicherschaltung, **dadurch gekennzeichnet, dass** es die Herstellung mindestens einer Speicherzelle enthält, die aufweist
- die Bildung auf einem Halbleitersubstrat einer Isolierschicht (CIS), die mindestens eine Folge von Potentialsenken aufweist, die im Wesentlichen in Abstand zur Oberfläche dieser Isolierschicht und zur Oberfläche des Substrats in einer Ebene im Wesentlichen parallel zur Oberseite des Substrats angeordnet sind,
- die Bildung eines Gate-Bereichs (GR) an der Oberfläche der Isolierschicht, wobei diese Bildung das Aufbringen einer Schicht von Gate-Material auf die Isolierschicht, das Ätzen der Schicht von Gate-Material mit Anhalten auf der Isolierschicht, und die Bildung von isolierenden Abstandshaltern auf den Flanken des Gates aufweist, und
- die Bildung von Source- (RS) und Drain-Bereichen (RD) zu beiden Seiten des Gates und in kapazitiver Kopplung mit den Potentialsenken, die sich in der Nähe der Enden der Isolierschicht befinden, wobei diese Bildung ein Ätzen der Isolierschicht zu beiden Seiten der Abstandshalter und eine Epitaxie aufweist, so dass die Source- und Drain-Bereiche mit den Enden der Isolierschicht in Kontakt kommen.

27. Verfahren nach Anspruch 26, **dadurch gekennzeichnet, dass** die Bildung der Isolierschicht die Bildung einer dielektrischen Umhüllung (ENR) aufweist, die die Potentialsenken bildenden Knoten (ND) umhüllt.

28. Verfahren nach Anspruch 27, **dadurch gekennzeichnet, dass** die Bildung der Umhüllung und der Knoten die Bildung einer unteren dielektrischen Schicht (CDI) auf der Oberfläche des Substrats, die Bildung von Knoten auf der unteren dielektrischen Schicht und die Bildung einer oberen dielektrischen Schicht (CDS) enthält, die die Knoten umhüllt und bedeckt.

29. Verfahren nach Anspruch 28, **dadurch gekennzeichnet, dass** die Bildung der Knoten (ND) eine knotenförmige Abscheidung eines kristallinen Materials aufweist, dessen Leitungsband einen niedrigeren Pegel hat als der Pegel des Leitungsbands des dielektrischen Materials zwischen Knoten.

## Claims

1. Integrated memory circuit, **characterized in that** it comprises at least one memory cell formed by a single transistor whose gate (GR) has a lower face insulated from the channel region (RC) by an insulation layer (CIS) containing at least one succession of potential wells (ND), which are substantially arranged at a distance from the gate and from the channel region in a plane substantially parallel to the lower face of the gate, and **in that** these potential wells (ND) are capable of containing an electric charge which is confined in the said plane and can be controlled to move in the said plane towards a first confinement region next to the source region (RS) or towards a second confinement region next to the drain region (RD), so as to define two memory states for the cell, the source (RS) and drain (RD) regions coming in contact with the lateral ends of the insulation layer.

2. Circuit according to Claim 1, **characterized in** the insulation layer (CIS) contains a dielectric encapsulation (ENR) encapsulating nodules which form the potential wells, these nodules being capable of carrying the said electric charge.

3. Circuit according to Claim 2, **characterized in that** the nodules (ND) are formed by a crystalline material whose conduction band has a level lower than the level of the conduction band of the inter-nodule dielectric material (ENR).

4. Circuit according to Claim 3, **characterized in that** the nodules (ND) have an intrinsic electric charge.

5. Circuit according to Claim 4, **characterized in that** the nodules (ND) are formed by a semiconductor material, for example silicon or a silicon alloy.

6. Circuit according to Claim 4 or 5, **characterized in that** it contains injection means (Vg) capable of injecting an additional electric charge into the encapsulation so as to charge at least some of the nodules.

7. Circuit according to Claim 3, **characterized in that** the nodules (ND) are free of intrinsic electric charge, and **in that** it contains injection means capable of injecting the said electric charge into the encapsulation so as to charge at least some of the nodules.

8. Circuit according to Claim 6 or 7, **characterized in that** the injection means contain biasing means (Vg) capable of biasing the gate, and **in that** the thickness (dv1) of the part of the insulation layer lying between the potential wells and the gate is different from the thickness (dv2) of the part of the insulation layer lying between the potential wells and the channel.

9. Circuit according to Claim 7, **characterized in that** the nodules (ND) are formed by an insulating material, for example silicon nitride.

10. Circuit according to Claim 5 or 9, **characterized in that** the inter-nodule dielectric material (ENR) contains silicon dioxide.

11. Circuit according to one of the preceding claims, **characterized in that** the average space (dh) between two nodules is less than the average diameter (D) of the nodules, less than the average distance (dv1) separating the nodules from the lower face of the gate and less than the average distance (dv2) separating the nodules from the channel region.

12. Circuit according to Claim 11, **characterized in that** the average space (dh) between two nodules is between about 0.5 and 3 nanometres.

13. Circuit according to one of the preceding claims, **characterized in that** the length (L) of the channel is less than or equal to 100 nanometres, for example equal to 50 nanometres.

14. Circuit according to one of the preceding claims, **characterized in that** the thickness (dv1) of the part of the insulation layer lying between the potential wells and the gate is between about 1 nanometre and about 10 nanometres, and **in that** the thickness (dv2) of the part of the insulation layer lying between the potential wells and the channel is between about 1 nanometre and about 10 nanometres.

15. Circuit according to one of the preceding claims, **characterized in that** the source and drain regions are arranged so as to be in capacitive coupling with the potential wells (ND) which lie in the vicinity of the ends of the insulation layer (CIS), and **in that** it contains biasing means (Vd, Vs) capable of biasing the source and drain regions of the transistor so as to move the electric charge towards the first confinement region (ZC1) or towards the second confinement region (ZC2).

16. Circuit according to one of the preceding claims, **characterized in that** it contains reading means capable of measuring the drain current for a given gate bias.

17. Circuit according to one of the preceding claims, **characterized in that** the insulation layer contains a plurality of successions of potential wells, respectively arranged in separate planes, all substantially parallel to the lower face of the gate.

18. Circuit according to one of the preceding claims, **characterized in that** it contains a memory plane (PM) formed by a plurality of memory cells, each memory cell being addressable individually.

19. Method for storing a binary datum in a memory cell of an integrated memory circuit, the cell containing a single transistor whose gate has a lower face insulated from the channel region by an insulation layer, **characterized in that** an electric charge is confined inside the insulation layer (CIS) at a distance from the gate and from the channel region in at least one plane substantially parallel to the lower face of the gate, and the electric charge is controlled to move in the said plane towards a first confinement region (ZC1) next to the source region or towards a second confinement region (ZC2) next to the drain region, as a function of the sign of the difference between the drain bias voltage (Vd) and the source bias voltage (Vs), so as to define two memory states for the cell corresponding to the logical values of the binary datum.

20. Method according to Claim 19, **characterized in that** the electric charge is confined in potential wells which are formed in the insulation layer.

21. Method according to Claim 20, **characterized in that** an electric charge is injected beforehand into the insulation layer.

22. Method according to Claim 21, **characterized in that** the electric charge is injected by biasing the gate, the thickness of the part of the insulation layer lying between the nodules and the gate being different from the thickness of the part of the insulation layer lying between the potential wells and the channel.

23. Method according to one of Claims 19 to 22, **characterized in that** the content of the memory cell is read by measuring the drain current for a given gate bias.

24. Method according to one of Claims 19 to 23, **characterized in that** the electric charge is confined in potential wells formed by nodules, which are capable of carrying the electric charge and are encapsulated in a dielectric encapsulation.

25. Method according to one of Claims 19 to 24, **characterized in that** the electric charge is confined in a plurality of separate planes substantially parallel to the lower face of the gate.

26. Method for fabricating an integrated memory circuit, **characterized in that** it comprises the production of at least one memory cell involving
- the formation, on a semiconductor substrate, of an insulation layer (CIS) containing at least one succession of potential wells which are substantially arranged at a distance from the upper surface of this insulation layer and from the upper surface of the substrate, in a plane substantially parallel to the upper face of the substrate,
- the formation of a gate region (GR) on the upper surface of the insulation layer, this formation involving the deposition of a layer of gate material on the insulation layer, etching of the layer of gate material with the etch-stop on the insulation layer, and the formation of insulating spacers on the sidewalls of the gate, and
- the formation of source (RS) and drain (RD) regions on either side of the gate and in capacitive coupling with the potential wells which lie in the vicinity of the ends of the insulation layer, this formation involving etching of the insulation layer on either side of the spacers and epitaxy such that the source and drain regions come in contact with the ends of the insulation layer.

27. Method according to Claim 26, **characterized in that** the formation of the insulation layer involves the formation of a dielectric encapsulation (ENR) encapsulating nodules (ND) which form the potential wells.

28. Method according to Claim 27, **characterized in that** the formation of the encapsulation and of the nodules involves the formation of a lower dielectric layer (CDI) on the upper surface of the substrate, the formation of nodules on the lower dielectric layer, and the formation of an upper dielectric layer (CDS) encapsulating and covering the nodules.

29. Method according to Claim 28, **characterized in that** the formation of the nodules (ND) involves nodular deposition of a crystalline material whose conduction band has a level lower than the level of the conduction band of the inter-nodule dielectric material.
